# EUROPEAN PATENT APPLICATION

(11) **EP 4 604 124 A1**
(43) Date of publication of application: **20.08.2025**
(21) Application number: 24305279.2
(22) Date of filing: 19.02.2024
(51) Int. Cl.: G11C 8/20, G11C 7/24, G11C 16/22, G11C 16/26, G11C 16/32

(54) **SECURE NON VOLATILE MEMORY**

(71) Applicant: THALES DIS FRANCE SAS, 92190 Meudon (FR)
(72) Inventor: NAURA, David, 13100 Aix en Provence (FR); BOUR, Laureline, 87470 Saint Maximin La Sainte Baume (FR)
(74) Representative: Bricks, Amélie

(57) **Abstract**

The invention relates to a non-volatile memory circuit (300) having an attack detector (390) comprising a supplemental bit line (BL') carrying supplemental memory cells (MC') located at the intersection with each word line (WLj). A supplemental polarization circuit (369) polarizes the supplemental bit line (BL'). The supplemental polarization circuit (369) provides a detection current higher than the current drawn by one supplemental memory cell (WC'), and lower than the current drawn by at least two memory cells (WC'). A supplemental reading amplifier (379) connected to the supplemental bit line (BL') can read a first state when one supplemental memory cell (WC') is selected by one word line (WLj) and can read a second state when two or more supplemental memory cells (WC') are simultaneously selected by at least two word lines (WLj). The supplemental reading amplifier (379) providing an alarm signal (ALARM) when the reading corresponds to the second state.

## Description

### Technical Field

The invention relates to a secure non-volatile memory and more particularly non-volatile memory using floating gate transistor.

### Background Art

Non-volatile memories are commonly used for memorizing information without power supply. Amongst the different categories of non-volatile memories, memories with floating gate transistor allow to be programmable and erasable, like Flash memories or EEPROMs (Electrically Erasable Programmable READ Only Memory).

One use of Flash or EEPROM memories is the storing of security data, in particular passwords but also secure programs for making strong authentications. Such kind of memories is commonly used in many products using secure element like smart cards, smartphones, computers, or any communicating electronic device that should be securely connected. Typically, such kind of memories are embedded in a microcontroller component making a verification of password in such a way the password never goes out of the component. Nevertheless, there are some methods for retrieving the password from such component.

One method consists in a direct access to the memory after removing protection resin from the component. Once the memory is naked, the memory can be accessed by thin probe or by laser. In such a way to avoid a direct reading of the memory, the memory can be scrambled or encoded.

Even if the memory is scrambled or encoded, a method, known as "fault attack", consists in altering the reading of the memory in such a way to cause some faults during the running of a secure program for locating where are the sensitive data. The fault introduction can be made by laser or by thin probes that can alter the state of some transistors. Today, it exists some protection circuit for detecting a laser attack on the memory cells and the attacks can be made on other location. In particular, it is possible to make an attack on a word line decoder for activating the reading of several words simultaneously. There is a need of additional protection circuit for detecting such kind of attacks.

### Summary of the Invention

The invention provides a memory comprising a circuit for raising an alarm in case of detection of a laser attack on a word line decoder during a reading of the memory. Such alarm can then be used for rebooting a microcontroller causing the aborting of the current running program.

More particularly, the invention provides a non-volatile memory circuit comprising a plurality of memory cells, a plurality of bit lines and a plurality of word lines, each memory cell comprising a floating gate transistor for memorizing a bit value and being located at an intersection of each bit line with each word line, said non-volatile memory circuit comprising a polarization circuit for polarizing the bit lines with a constant reading current, and reading amplifiers connected to bit lines for reading the value of memory cells selected by one of the word lines. The non-volatile memory circuit further comprises an attack detector comprising a supplemental bit line, supplemental memory cells located at the intersection of the supplemental bit line with each word line, a supplemental polarization circuit for polarizing the supplemental bit line, and a supplemental reading amplifier. The supplemental polarization circuit provides a constant detection current higher than the current that can be drawn by one selected of the supplemental memory cells, and lower than the current that can be drawn by two selected of the supplemental memory cells, in such a way that the supplemental reading amplifier can read a first state on the supplemental bit line when only one supplemental memory cell is selected by one word line, and can read a second state on the supplemental bit line when two or more supplemental memory cells are simultaneously selected by at least two word lines. The supplemental reading amplifier provides an alarm signal when the reading corresponds to the second state.

For avoiding false detection, the detection circuit can comprise a second input terminal receiving an attack detection signal, and wherein the alarm signal is provided only if the attack detection signal is activated.

According to a preferred embodiment, the supplemental reading amplifier can comprise at least one differential amplifier powered through a controlled switch controlled by the validation signal.

To have a synchronous alarm signal, the supplemental reading amplifier can comprise a latch of D-type for latching the alarm signal together with a latching of a data read by the reading amplifiers.

According to a choice of design, the supplemental memory cells can be all in an erasing state.

According to another aspect, the invention provides a method for detecting a reading error caused by a photoelectric or radiative attack on a non-volatile memory having memory cells connected to at least one bit line at the intersection of a plurality of word lines, and comprising each a floating gate transistor, wherein the reading of a memory cell is made by pre-charging a bit line to a preload voltage and comparison of the bit line voltage to this preload voltage after a reading time during which a selected cell charges or discharges the bit line polarized by a constant reading current. The method for detecting the reading error is made by reading supplemental memory cells which are located on a supplemental bit line polarized by a constant detection current, all supplemental memory cells being located at the intersection of each word line with the supplemental bit line, wherein the constant detection current is higher than the current that can be drawn by one supplemental memory cell, and lower than the current drawn by two supplemental memory cells, in such a way that a reading of the supplemental bit line corresponds to a first state when only one supplemental memory cell is selected by one word line, and corresponds to a second state when two or more supplemental memory cells are simultaneously selected by at least two word lines and wherein an alarm signal is provided when the reading corresponds to the second state.

According to a choice of design, the supplemental memory cells can be all in an erasing state.

For avoiding false detection, the alarm signal can be provided only if an attack detection signal is activated.

To have a synchronous alarm signal, the alarm signal can be latched together with a latching of a data read in the memory.

### Brief description of the Drawings

The invention will be detailed with reference to the annexed drawings in which:
Figure 1 shows a microcontroller type circuit including a non-volatile memory,
Figure 2 shows a structure of a non-volatile memory circuit according to the invention,
Figure 3 details a part of a bit line and of an attack detector according to the invention,
Figure 4 shows a timing diagram of a reading operation in normal condition,
Figure 5 shows a timing diagram of an attack detection during a reading operation,
Figure 6 discloses a possible variant of an element of the attack detector of the invention.

### Detailed Description of the invention

In such a way to simplify the present specification, a same reference is used on different drawings for designing a same element or an equivalent element. In addition, only parts of the memory are shown on the drawings for avoiding a surcharge that may render the drawings unreadable. Timing diagrams are not made with an exact scale for showing details that cannot be shown otherwise.

In the present document, it will be referred to active signal, inactive signal, high level, low level, level "1" and level "0". As well known by a person skilled in the art, levels "0" and "1" and a low or a high level can arbitrarily correspond to an active and inactive levels depending on the kind of transistor used or of simple choice of the designer. So, changing a high level to a low level or a level "1" to a level "0" has no importance in relation with the invention.

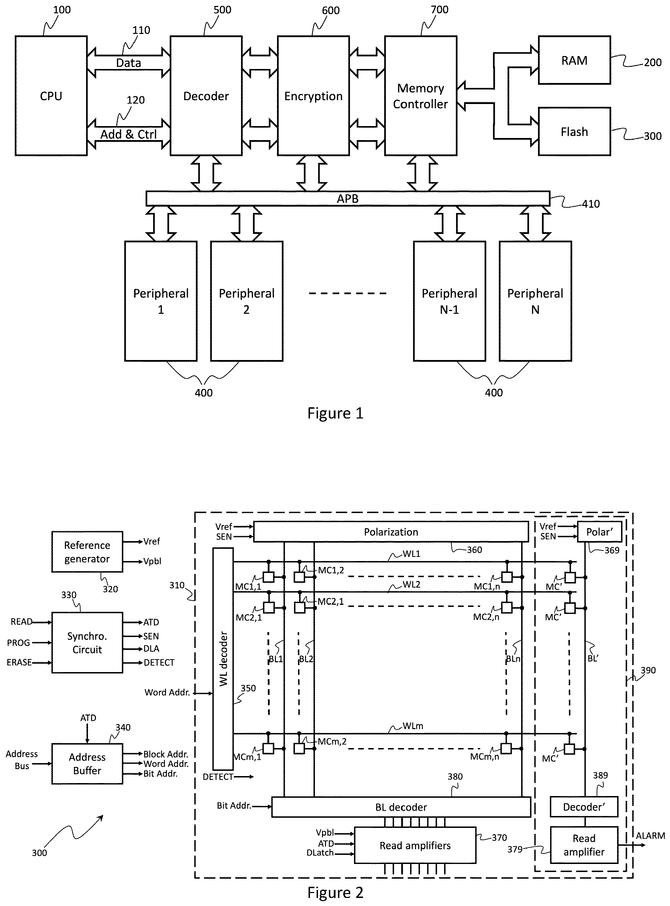

The invention is related to the security of a non-volatile memory. Such non-volatile memories are generally included in a microcontroller circuit that can be also known as System-On-Chip (SOC). As an example, a microcontroller is shown on figure 1 for showing the context of use of a memory according to the invention. The microcontroller of figure 1 comprises a central processing unit (CPU) 100 that may include one or more microprocessor cores. The CPU 100 comprises a data bus 110, and an address and control bus 120 for communicating with memories 200 and 300 and with peripheral units 400. For securely managing the memories 200 and 300 or the peripheral units 400, the microcontroller can comprise a decoder circuit 500, an encryption circuit 600 and a memory controller 700, both connected to the data bus 110 and the address and control bus 120 and to an application peripheral bus 410 for connecting the peripheral units 400.

Typically, control signals and address format depend on the memory type, and it is necessary to adapt them to be transparent for the CPU. The memory controller 700 can be used for addressing each memory 200 or 300 with address and control signals adapted to each type of memory that can be volatile memory 200, for example of RAM type, or non-volatile memory, for example of Flash type.

The encryption circuit 600 can be used for secure circuit, it can be of different type and can be controlled by the CPU for encrypting the data transmitted to the memories or to the peripheral units or for scrambling the addresses of the data into one memory. The encryption circuit 600 can be also transparent if no security is required for the transferred data.

The decoder circuit 500 can be used for decoding some control signals of the CPU in such a way to address the memories 200 or 300, one peripheral unit 400, or to control the encryption circuit 600 or for establishing a data transfer between one of the memories 200 or 300 and one peripheral unit 400, eventually through the encryption circuit 600.

Many other architectures are possible using different communication path between a CPU, its memories, and its peripherals units. Figure 1 showing only one example amongst many other possibilities, many functional variants of the decoder circuit 500, the encryption circuit 600, and the memory controller 700 are possible and they can be also optional. For the invention, one important thing is that a CPU 100 is connected directly or indirectly to a non-volatile memory 300 in view to read data that can be encrypted or scrambled or not. According to the invention the non-volatile memory 300 is capable to send a signal to the CPU 100 for indicating when an attack has been made during a reading operation.

The figure 2 illustrates an example of a non-volatile memory 300 according to the invention, for example a Flash memory, having a size that is small enough to be implemented into a SOC. The memory 300 can comprise one or more memory block 310 but only one is represented for simplifying the drawing. The memory further comprises a reference generator 320, a synchronization circuit 330 and an address buffer 340 for synchronizing the memory. For simplification reasons, only signals used for a reading operation are indicated on the drawing.

The memory block 310 comprises a plurality of word lines WL1 to WLm, a plurality of bit lines BL1 to BLn and a plurality of memory cells MC1,1 to MCm,n, each memory cell MCj-i being located and connected at the intersection of one word line WLj with one bit line BLi. The memory block 310 further comprises a word line decoder 350, a polarization circuit 360, read amplifiers 370, a bit line decoder 380 and an attack detector 390.

The reference generator 320 provides a first reference voltage Vref and a second reference voltage Vpbl. The reference generator 320 contains a stabilized current source and the first reference voltage Vref corresponds to the intermediate voltage of a current mirror which is provided to the polarization circuit 360 for enabling the polarization circuit 360 to mirror and to provide this stabilized current to each bit line BL1 to BLn in such a way to polarize said bit lines BL1 to BLn with a constant reading current. The second reference voltage Vpbl correspond to a preload voltage of the bit line used for starting each reading operation.

The synchronization circuit 330 receives the external control signals provided by the memory controller 700 which correspond to a reading signal READ, a programing signal PROG and an erasing signal ERASE. Each of these signals READ, PROG and ERASE triggers a sequence of signals to the different circuits constituting the memory circuit 300 for providing the requested operation. In the present specification, only the signals used for a reading operation will be detailed. The activation of the reading signal READ triggers an address validation signal ATD, a sensing signal SEN, a data latching signal DLA and an attack detection signal DETECT with timing detailed later in this document. The address validation signal ATD is provided to the address buffer 340 and to the read amplifier 370. The sensing signal SEN is provided to the polarization circuit 360. The data latching signal DLA is provided to the read amplifiers 370. The attack detection signal DETECT is provided to the attack detector 390.

The address buffer 340 receives the address of the data to be read from an address bus connected to the memory controller 700. The address can be multiplexed by the CPU 100, and can be demultiplexed by said memory controller, as well known by a person skilled in the art. In this document, the full address is received in parallel by the address buffer 340 from the memory controller 700. The address buffer 340 memorizes the full address at the beginning of the read operation triggered by the address validation signal ATD and till the end of the read operation for providing different address segment to several elements of the memory 300. A first segment is the block address that controls the powering of the memory block into which the reading operation is to be performed. A second segment is the word address which is sent to the word line decoder 350 for selecting one word line WLj. A third segment is the bit line address which is sent to the bit line decoder 380 for selecting one or more bit lines that correspond to the read data, depending on the number of bits that are corresponding to a data word.

The word line decoder 350 is a demultiplexer circuit that provides an active level to one word line WLj corresponding to the word address provided by the address buffer 340 while the other word lines are at an inactive level. The word line decoder 350 selects the reading of all the memory cells MCj,1 to MCj,n connected to the selected word line WLj.

The polarization circuit 360 provides a same and constant reading current to all the bit lines BL1 to BLn when the sensing signal SEN is active. The constant reading current polarizes the bit lines BL1 to BLn and participates to the charging and discharging of said bit line BL1 to BLn during the reading of the memorized value of the selected memory cells MCj,1 to MCj,n connected to the bit lines BL1 to BLn.

The read amplifiers 370 comprise amplification circuits connected to bit lines for reading the value of selected cells after a reading time. In view to read the value, the read amplifiers 370 charge the bit line to the second reference voltage Vpbl under the control of the address validation signal ATD. Then, the bit lines are charged or discharged during a reading time, and the read values are latched by the data latching signal DLA.

The bit line decoder 380 is a multiplexer connected between the read amplifiers 370 and the memory cells MCj,i for selecting the bit lines to be read. With such a selection of bit lines, the number of read amplifiers 370 can be reduced to the number of bits of a data word instead of having has many amplifiers than bit lines.

The attack detector 390 comprises a supplemental bit line BL' comprising a plurality of supplemental memory cells MC' located at an intersection with one of the word lines WL1 to WLm. The attack detector 390 further comprises a supplemental polarization circuit 369, a supplemental read amplifier 379, and a supplemental decoder 389. The supplemental polarization circuit 369 provides a constant detection current to all the supplemental bit line BL' when the sensing signal SEN is active. The constant detection current is different than the constant reading current and it will be details later in this document. The supplemental read amplifiers 379 comprise amplification circuits connected to supplemental bit line BL' for reading a value of the supplemental bit line BL' depending on the selected supplemental memory cells MC'. The supplemental read amplifier 379 is similar to the read amplifiers 370 but provides an alarm signal ALARM depending on the value read on the supplemental bit line BL'. The supplemental bit line decoder 389 is optional and can be used only for having a same capacitive load on the supplemental bit line BL' than on a selected bit line BLi.

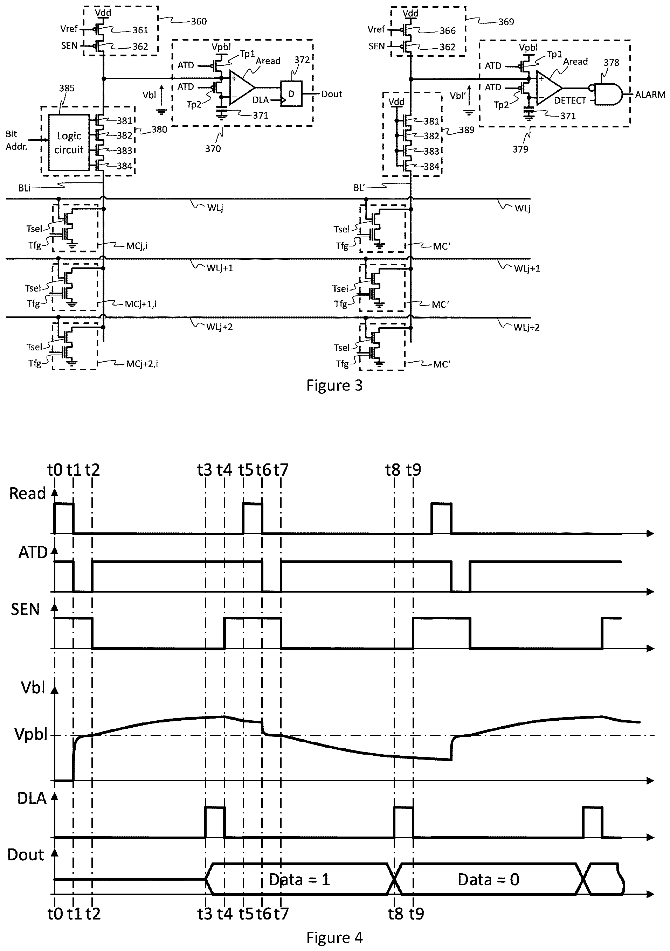

Other memory structure can implement the invention. The place of the element can be moved for optimizing the placing without changing the function. In view to explain how is made a reading operation with and without attack, the figure 3 details the different elements of the memory 300 in relation with one bit line BLi and in relation with the attack detector 390. As it can be seen on the figure 3 the elements of figure 2 are not located at the same places and enable to reduce the size of the polarization circuit 360.

For simplifying the drawings, only three word lines WLj, WLj+1 and WLj+2 are represented but, as well known by a person skilled in the art, the number m of word lines is much higher, for example m can be equal to 2¹⁰. The polarization circuit 360, the read amplifiers 370, and the bit line decoder 380 are limited to their components connected only to one bit line BLi.

The bit line decoder 380 comprises decoding transistors 381 to 384 serially mounted between the selected bit line BLi and the read amplifiers 370. The bit line decoder 380 comprises a logic circuit 385 that decodes the bit line address for controlling said decoding transistors 381 to 384. A person skilled in the art will understand that the polarization circuit 360 and the read amplifiers 370 are also connected to other bit lines through other decoding transistors (not shown) that are unselected by the bit line decoder 380. In addition, the polarization circuit 360, the read amplifiers 370, and the decoding transistors 381 to 384 are repeated for each group of bit lines corresponding to another bit of the data which is read simultaneously while the attack detector is unique for a memory block.

As it can be seen on figure 3, the polarization circuit 360 comprises a mirror transistor 361 and a sensing transistor 362. The mirror transistor 361 is identical to a transistor located into the reference generator 320 for mirroring a reference current used for polarizing the bit line BLi at a constant reading current. The sensing transistor 362 is driven by the sensing signal SEN in such a way to provide the constant reading current to the bit line BLi only when the sensing signal SEN is active at a low level.

The read amplifiers 370 comprise a differential amplifier Aread, first and second preload transistors Tp1 and Tp2, a capacitor 371 and a latch 372 of D type. The differential amplifier Aread comprises two inputs and provides at its output a signal corresponding to the amplified difference between its inputs. A drain of first preload transistor Tp1 and a source of the second preload transistor Tp2 are connected to one of the inputs of the differential amplifier Aread. A drain of the second preload transistor Tp2 is connected to the other of the inputs of the differential amplifier Aread. A source of the first preload transistor Tp1 is connected to the reference generator 320 for receiving the second reference voltage Vpbl. The capacitor 371 is connected between the drain of the second preload transistor Tp2 and the ground of the memory circuit 300. The gates of the first and second preload transistors Tp1 and Tp2 both receive the address validation signal ATD for charging the capacitor 371 and the bit line BLi to the second reference voltage Vpbl when the address validation signal ATD is active. The latch 372 is connected at the output of the differential amplifier Aread for latching the read data under the control of the data latching signal DLA.

Each memory cell MCj,i comprises a floating gate transistor Tfg and a selection transistor Tsel. A gate of the selection transistor Tsel is connected to the word line WLj. A drain of the selection transistor Tsel is connected to the bit line BLi. A source of the selection transistor Tsel is connected to the drain of the floating gate transistor Tfg. A source of the floating gate transistor Tfg is connected to a ground voltage. The gate of the floating gate transistor Tfg is used for erasing and programming the bit memorized by the floating gate transistor and can be unconnected or can be polarized with a reading voltage for adjusting the current in the memory cell MCj,i during the reading operation. The memory cell MCj,i memorizes a bit value corresponding to a quantity of charges accumulated in the floating gate of the floating gate transistor Tfg. The value "0" or "1" of a memorized bit can be arbitrarily associated to the fact that the floating gate is charged or discharged. In the present document the bit value "0" corresponds to charged floating gate. In the present example, when a memory cell MCj,i is in an erased state the floating gate of the floating gate transistor Tfg is charged, allowing to pass a nominal current when the memory cell MCj,i is selected. In a programmed state, the gate is discharged in such a way that the floating gate transistor Tfg remains blocked when the memory cell MCj,i is selected.

In addition, the selection transistor Tsel of each cell being a N-channel transistor made on a P-substrate. When the selection transistor Tsel is blocked, this transistor Tsel corresponds electrically to a small capacitor. The small capacitor multiplied by the number of memory cells MCj,i connected to the bit line BLi defines the total capacitance of the bit line BLi.

The person skilled in the art knows that such kind of memory is sized to be small with a low consumption. The size of the transistors constituting the memory cells MCj,i limits the current flowing through the memory cells and defines the global capacitance of the bit line BLi. In addition, each memory cell MCj,i, can have a current leakage, and a global current leakage must be considered. As an example, if the global current leakage is around 2 mA, the floating gate transistor (Tfg) can be sized for enabling to pass a current of 12 mA, while the polarization circuit 360 provides a constant reading current of 8 mA, in such a way that the bit line can be charged or discharged with a current of +/- 6 mA. The time for totally charging or discharging the bit line BLi depends on the number of cells connected to the bit line and can be around 40 ns for a complete charging with 2¹⁰ memory cells connected to one bit line. For preloading the bit line, the first preload transistor Tp1 (which are in lower number than memory cells) can be much larger for reducing the preload time for example to 2 ns.

Regarding the attack detector 390, it corresponds to a duplication of the elements used for one bit line but with some little differences. The supplemental memory cells MC' can be identical to the other memory cells MCj,i but are all in a same state, as an example, the state corresponding to an erased cell.

The supplemental polarization circuit 369 comprises a mirror transistor 366 and a sensing transistor 362 as the polarization circuit 360. The mirror transistor 366 receives the first reference voltage Vref but is sized differently than the mirror transistor 361 for providing the constant detection current which is different than the constant reading current. The sensing transistor 362 is driven by the sensing signal SEN in such a way to provide the constant detection current to the supplemental bit line BL' when the sensing signal SEN is active at a low level.

The supplemental read amplifier 379 comprises a differential amplifier Aread, first and second preload transistors Tp1 and Tp2, and a capacitor 371 connected in a same manner than the read amplifier 370. But, in this example, the supplemental read amplifier comprises a AND gate 378 having one inverted input connected at the output of the differential amplifier Aread, another input receiving the attack detection signal DETECT, and providing the alarm signal ALARM on its output.

As it can be seen on figure 3, the supplemental bit line decoder 389 comprises decoding transistors 381 to 384 serially mounted between the supplemental bit line BL' and the supplemental read amplifier 379. The gate of the decoding transistors 381 to 384 are all connected to the power voltage supply Vdd in such a way they are always passant. Alternately, the supplemental bit line decoder 389 can be replaced by a wire liking the supplemental bit line BL' to the supplemental read amplifier 379.

As indicated before the constant detection current is different than the constant reading current while the supplemental memory cells MC' are the same than the memory cells MCj,i. The aim of the supplemental bit is to detect if only one or several word lines WLj are selected. Considering the global current leakage is around 2 mA, and that the floating gate transistor Tfg are sized for enabling to pass a current of 12 mA in an erased state, the constant detection current can be set at 16 mA, the mirror transistor 366 having the channel width twice the channel width of the mirror transistor 361. If only one word line WLj is selected the supplemental bit line BL' can be charged with a current of +2 mA. If two word lines WLj and WLj+1 are simultaneously selected due to a laser attack, then the supplemental bit line BL' can be discharged with a current of - 10 mA. If more than two word lines WLj are simultaneously detected due to a laser attack, then the supplemental bit line BL' can be discharged with a current more important than -10 mA.

Before detailing the functioning of attack detector 390, a normal reading operation is detailed in relation with figure 4. For reading a data word, the address bus of the non-volatile memory 300 should be charged by the memory controller 700 with an address corresponding to a data word to be read, as an example the data word to be read comprises a bit located in the memory cell MCj,i. Then the memory controller 700 activate the reading signal READ at time t0 for indicating to the non-volatile memory 300 that a read operation must be performed. In response to the reading signal READ, the synchronization circuit 330 activates the address validation signal ATD at a time t1 till a time t2. As an example, time t1 can be set 2 ns after time t0 and time t2 can be set 2 ns after time t1. The activation of the address validation signal ATD causes the address buffer 340 to memorize the address at time t1. The address buffer 340 provides immediately at the time t1 the block address to switch on the selected memory block, and the bit address corresponding to the bit line BLi for connecting the selected bit line BLi through the decoding transistors 381 to 384.

During the activation of the address validation signal ATD, the first and second preload transistors Tp1 and Tp2 are switched on and the bit line BLi is preload to the second reference voltage Vpbl. It should be noted by the person skilled in the art that the channel width of the first preload transistor Tp1 must be sized for driving the bit line voltage at the second reference voltage Vpbl before the time t2.

At time t2, the address buffer 340 provides the word address that selects the word line WLj. The selection transistor Tsel of memory cell MCj,i switches to a conducting state at this moment.

At time t2, the synchronization circuit 330 deactivates the address validation signal ATD and activates sensing signal SEN. The deactivation of the address validation signal ATD blocks the first and second preload transistors Tp1 and Tp2. The activation of the sensing signal SEN connects the mirror transistor 361 to the bit line BLi through the sensing transistor 362. Considering that the floating gate of the floating gate transistor Tfg of memory cell MCj,i is discharged, the floating gate transistor Tfg of the selected memory cell MCj,i is in open circuit. The stabilized current provided by the mirror transistor 361 can charge the capacitance of the bit line BLi, increasing the bit line voltage Vbl.

At time t3, the synchronization circuit 330 activates the data latching signal DLA. The bit line BLi being at a voltage higher than the second reference voltage Vpbl memorized by the capacitor 371, the output of the differential amplifier is at high level, and the latch 372 memorizes and provides at its output a bit value equal to "1". It should be noted that the time t3 is set to a value corresponding to a sufficient time for significatively charging or discharging the bit line for having a good reading of the cell level, but it is not necessary to wait a complete charging or discharging of the bit line. As an example, time t3 can be set to 20 ns after time t2 for warranting that the charging or discharging of bit line enables to have a good reading whatever the wear of the floating gate transistors.

At a time t4, after time t3, for example 1 ns later, the synchronization circuit 330 deactivates the sensing signal SEN and a new reading operation can be initiated by the memory controller 700, presenting a new address, as an example the data to be read comprises a bit located in the memory cell MCj+1,i and containing a "0" value. The memory controller 700 activates the reading signal READ at time t5 for indicating to perform a new read operation. In response, the synchronization circuit 330 activates the address validation signal ATD at a time t6 till time t7.

The first and second preload transistors Tp1 and Tp2 preloads the bit line BLi at the second reference voltage Vpbl before the time t7. At time t7, the address buffer 340 provides the word address that selects the word line WLj+1. The selection transistor Tsel of memory cell MCj+1,i switches to a conducting state at this moment.

At time t7, the synchronization circuit 330 deactivates the address validation signal ATD and activates sensing signal SEN. The deactivation of the address validation signal ATD blocks the first and second preload transistors Tp1 and Tp2. The activation of the sensing signal SEN connects the mirror transistor 361 to the bit line BLi through the sensing transistor 362. Considering that the floating gate of the floating gate transistor Tfg of memory cell MCj+1,i is charged, the floating gate transistor Tfg of the selected memory cell MCj,i is in a conducting state. The stabilized current provided by the mirror transistor 361 is driven to the ground together with the charges of the bit line BLi, decreasing the bit line voltage Vbl.

At time t8, the synchronization circuit 330 activates the data latching signal DLA. The bit line BLi being at a voltage lower than the second reference voltage Vpbl memorized by the capacitor 371, the output of the of the differential amplifier is at low level, and the latch 372 memorizes and provides at its output a bit value equal to "0". Another read operation can be performed after a time t9 corresponding to a deactivation of the sensing signal SEN.

When a laser attack is made on the word line decoder 350, several word lines WLj can be activated at a same time. The reading can be then made on several memory cells of a bit line BLi. When a selected memory cell is in a programmed state and an additional memory cell in an erased state is connected to the bit line by the laser attack on another word line, a reading error occurs because the reading of an erased memory cell is made by the read amplifier 370 instead of the reading of the selected programmed cell.

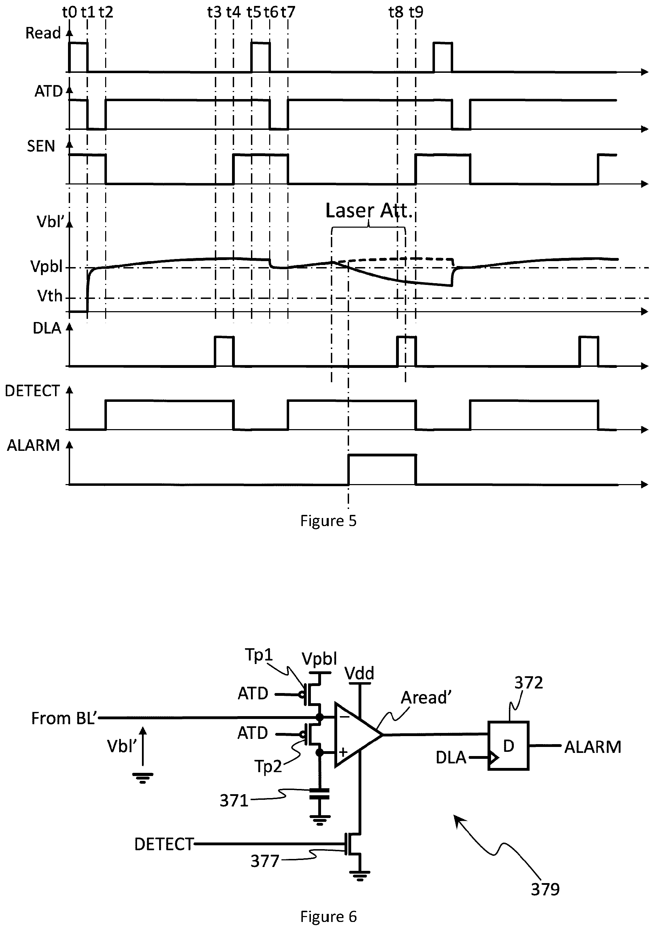

The figure 5 explains how the laser attack can be detected by the attack detector 390. The figure 5 shows how is read the supplemental bit line for detecting a reading error. To be efficient, a laser attack is synchronized with a read operation. The hacker must synchronize the laser attack with the sensing signal in such a way that the laser attack occurs after the preload of the bit line BLi. As shown on figure 5. From time t0 to time t4 a first reading operation is made without attack while a laser attack occurs during a second reading operation from time t5 to t9.

As it can be seen on figure 5, the normal reading operation is made between time t0 and t4. A reading operation is made on the supplemental bit line BL' in a same manner than previously described and the voltage Vbl' increases slowly at time t2 because the supplemental bit line is charged with a current of +1,5 mA. The voltage Vbl' being always higher than the second reference voltage Vpbl memorized by the capacitor 371, the output of the differential amplifier Aread is at high level, and the output of the AND gate 378 remains always to an inactivated "0" level even when the attack detection signal DETECT is active.

The attack occurs during the second reading operation between t5 and t9. A reading operation is made on the supplemental bit line BL' in a same manner than previously described but the attack occurs after t7, i.e. after the sensing signal SEN indicates the reading is in progress. The voltage Vbl' starts to increase slowly at time t7 because the supplemental bit line BL' is charged with a current of +1,5 mA. But when the laser attack is effective, at least a second word line is activated and at least two supplemental memory cells MC' are connected to the supplemental bit line BL4 and discharge said supplemental bit line BL' with a current of -10 mA causing the voltage Vbl' to strongly decrease. When the voltage Vbl' is lower below the second reference voltage Vpbl memorized by the capacitor 371, the output of the differential amplifier Aread toggles to a low level, and the alarm signal ALARM is activated for indicating that an attack is occurring.

The alarm signal ALARM can then toggle an interruption of the reading by the memory controller 700 or can toggle an asynchronous interruption at the CPU level for aborting the current running program.

As disclosed, the management of the alarm signal ALARM is made asynchronously. For a synchronous management of the alarm signal ALARM, it is possible to replace the supplemental reading amplifier 379 of figure 3 by the supplemental reading amplifier of figure 6.

The read amplifier 379 of figure 6 comprises a differential amplifier Aread', first and second preload transistors Tp1 and Tp2, a capacitor 371, a latch 372 of D type, and a switching transistor 377. The switching transistor 377 switch the power supply of the differential amplifier Aread' and is controlled by the attack detection signal DETECT in such a way the output of the differential amplifier Aread' is always at low level when the attack detection signal DETECT is inactive. The differential amplifier Aread' has its input inverted with reference to the differential amplifier Aread in such a way to provide a high level when the voltage Vbl' of the supplemental bit line BL' is lower than the voltage at the terminal of the capacitor 371, and a low level when the voltage Vbl' of the supplemental bit line BL' is higher than the voltage at the terminal of the capacitor 371. The first and second preload transistors Tp1 and Tp2, the capacitor 371 and the latch 372 are connected in the manner than the differential amplifiers 370. The output of the differential amplifier Aread' provides a voltage level corresponding to the alarm signal ALARM of the figure 5 but the latch delays the alarm signal ALARM to becomes active at the same moment of a data is read. With such an improvement, the alarm signal ALARM becomes synchronized with the read data and the memory controller can ignore the read data and can repeat the read operation.

The invention is not limited by the example described in the present specification. In particular, the memory circuit could not be integrated inside a microcontroller or a SOC but could be a memory circuit connected to an external CPU. The alarm signal can be used for other purpose than restarting the CPU.

In present example, a programmed memory cell corresponds to a floating gate discharged while an erased memory cell corresponds to a charged floating gate. This is a choice design and if the choice is reversed then the supplemental cell should correspond to programmed cell, i.e. charged floating gate.

The current value and the sizing of the transistors indicated in the present document were indicated as illustrative example and the man of the art will understand that the current values can be different and that the ratio of current between the bit lines BLi and the supplemental bit line BL' can be different than two. The adaptation of the current values should be made as a function of the current drawn by the floating gate transistor of a memory cell and can be also adapted to a dispersion of current that can be drawn by the floating gate transistors of all the memory. The importance in the choice is that the current corresponding to one floating gate transistor enables to charge or discharge the supplemental bit line BL' for reading a first state and that the current corresponding to at least two floating gate transistors discharge or charge the supplemental bit line BL' for reading a second state.

## Claims

1. A non-volatile memory circuit (300) comprising a plurality of memory cells (MC1,1 to MCm,n), a plurality of bit lines (BL1 to BLn) and a plurality of word lines (WL1 to WLm), each memory cell (MCj,i) comprising a floating gate transistor (Tfg) for memorizing a bit value and being located at an intersection of each bit line (BLi) with each word line (WLj), said non-volatile memory circuit (300) comprising a polarization circuit (360) for polarizing the bit lines (BLi) with a constant reading current, and reading amplifiers (370) connected to bit lines (BLi) for reading the value of memory cells (MCj,i) selected by one of the word lines (WLj), **characterized in that** it further comprises an attack detector (390) comprising a supplemental bit line (BL'), supplemental memory cells (MC') located at the intersection of the supplemental bit line (BL') with each word line (WLj), a supplemental polarization circuit (369) for polarizing the supplemental bit line (BL'), and a supplemental reading amplifier (379), wherein the supplemental polarization circuit (369) provides a constant detection current higher than the current that can be drawn by one selected of the supplemental memory cells (WC'), and lower than the current that can be drawn by two selected of the supplemental memory cells (WC'), in such a way that the supplemental reading amplifier (379) can read a first state on the supplemental bit line (BL') when only one supplemental memory cell (WC') is selected by one word line (WLj), and can read a second state on the supplemental bit line (BL') when two or more supplemental memory cells (WC') are simultaneously selected by at least two word lines (WLj), said supplemental reading amplifier (379) providing an alarm signal (ALARM) when the reading corresponds to the second state.

2. The non-volatile memory circuit of claim 1, wherein the detection circuit (390) comprises a second input terminal receiving an attack detection signal (DETECT), and wherein the alarm signal (ALARM) is provided only if the attack detection signal (DETECT) is activated.

3. The non-volatile memory circuit of claim 2, wherein the supplemental reading amplifier (379) comprises at least one differential amplifier (Aread') powered through a controlled switch (377) controlled by the validation signal (DETECT).

4. The non-volatile memory circuit according one of the claims 1 to 3, wherein the supplemental reading amplifier (379) comprises a latch (372) of D-type for latching the alarm signal together with a latching of a data read by the reading amplifiers (370).

5. The non-volatile memory circuit according one of the claims 1 to 4, wherein the supplemental memory cells (MC') are all in an erasing state.

6. A method for detecting a reading error caused by a photoelectric or radiative attack on a non-volatile memory having memory cells (MCj,i) connected to at least one bit line (BLi) at the intersection of a plurality of word lines (WLj), and comprising each a floating gate transistor (Tfg), wherein the reading of a memory cell (MCj,i) is made by pre-charging a bit line (BLi) to a preload voltage (Vpbl) and comparison of the bit line voltage (Vbl) to this preload voltage (Vpbl) after a reading time during which a selected cell (MCj,i) charges or discharges the bit line (BLi) polarized by a constant reading current, **characterized in that** the method for detecting the reading error is made by reading supplemental memory cells (MC') which are located on a supplemental bit line (BL') polarized by a constant detection current, all supplemental memory cells (MC') being located at the intersection of each word line (WLj) with the supplemental bit line (BL'), wherein the constant detection current is higher than the current that can be drawn by one supplemental memory cell (MC'), and lower than the current drawn by two supplemental memory cells (MC'), in such a way that a reading of the supplemental bit line (BL') corresponds to a first state when only one supplemental memory cell (WC') is selected by one word line (WLj), and corresponds to a second state when two or more supplemental memory cells (WC') are simultaneously selected by at least two word lines (WLj) and wherein an alarm signal (ALARM) is provided when the reading corresponds to the second state.

7. The method of claim 6, wherein the supplemental memory cells (MC') are all in an erasing state.

8. The method of claim 6 or 7, wherein the alarm signal (ALARM) is provided only if an attack detection signal (DETECT) is activated.

9. The method according one of the claims 6 to 8, wherein the alarm signal (ALARM) is latched together with a latching of a data read in the memory.
